# EUROPEAN PATENT APPLICATION

(11) **EP 0 723 387 A1**
(43) Date of publication of application: **24.07.1996**
(21) Application number: 96300089.8
(22) Date of filing: 04.01.1996
(51) Int. Cl.: H05K 3/34

(54) **Soldermask gasketing of printed wiring board surface mount pads**

(30) Priority: 19.01.1995 US 375037
(71) Applicant: DIGITAL EQUIPMENT CORPORATION, Maynard, Massachusetts 01754-1499 (US)
(72) Inventor: Beckman, Steven J., Harvard, Massachusetts 01451 (US); Dunbar, Mark, Princeton, Massachusetts 01543 (US); Hartmann, Thomas W., Wales, Massachusetts 01081 (US); Bloch, Carl, Wayland, Massachusetts 01778 (US)
(74) Representative: Goodman, Christopher

(57) **Abstract**

An apparatus and a method is described to provide a printed wiring board which includes a substrate (10) having electrical contact pads (12) disposed over a surface of the substrate, with the contacts having a patterned solder mask (14) with an aperture (14') that exposes less than the entire surface of the electrical contact pads (12). Thus by providing a soldermask aperture (14') that exposes less than the entire surface of the contact (12), the aperture (14') can be used to completely contain liquid solder material (16) from the solder reflow attach operation.

## Description

### BACKGROUND OF THE INVENTION

This invention relates generally to the mounting of electronic devices on printed wiring boards (PWBs) and more particularly to the printing of solder paste patterns on PWBs for the surface mount solder attachment of the electronic device leads.

As is known in the art, liquid materials, called soldermasks, are applied to PWBs to prevent unwanted process induced solder bridges from electrically shorting out adjacent electronic component lead attach pads. The liquid solder mask materials can be applied to the PWB surface in several ways. The solder mask can be "squeegeed" onto the PWB through a patterned screen known as a "silk screen" or a "stencil", resulting in a pre-patterned layer of solder mask material, but with a more limited feature density than desired in the art. Alternatively, the solder mask can be applied as a blanket layer to the PWB by spinning the PWB under a stream of liquid solder mask, or by spraying the liquid solder mask directly onto the PWB, or by dipping the PWB into a bath of liquid solder mask material, or numerous other methods as is well known in the art. The blanket of solder mask material is then patterned by any of the photolithography processes well known in the art. The solder mask can be either negative or positive photolithgraphic optical polarity. If the solder mask is of positive type, then the areas that are exposed to light become more soluble in a developing solution, and are thus removed leaving an aperture in the solder mask at the desired location. If the solder mask is of negative type, then the areas that are exposed to light become less soluble in a developing solution, and thus remain at the desired location.

With any of these approaches, several problems can occur with the alignment of the soldermask to the space between the PWB metallization contact pads, and with the adhesion of the soldermask material on the narrow PWB laminate space between fine pitched (ie closely spaced) metal pads. These above mentioned problems are related to the requirement in the art that the aperture in the solder mask completely surround the PWB metallization contact pads and that none of the solder mask material be left on the PWB metallization contact pads. These problems and others have become more critical as the density requirements of electronic modules have increased, since an increase in density requires a concurrent decrease in both conductor width and spacing between conductors.

The result of the two conflicting interests mentioned above, that is the desire to have a soldermask that prevents solder shorting between metal pads, and the requirement that the soldermask not encroach upon the metal pads, leads to a design tradeoff which either sacrifices very fine pitch interconnect density, or which omits the soldermask between adjacent fine pitch electronic pads leading to an increase in solder shorting defects on the PC boards. Thus electronic modules are not as dense and as reliable as they could otherwise be.

Thus there is a need in the art for a soldermask that combines the advantages of the soldermask for solder bridging prevention with the ability to make a reliable electronic module as compact and dense as if a soldermask were not used.

### SUMMARY OF THE INVENTION

The invention in its broad form resides in a printed wiring board and a method as respectively recited in claims 1 and 5. As described hereinafter, a printed wiring board includes a substrate having at least one electrical contact pad disposed over a surface of said substrate, said contact having a first surface parallel to the surface of the substrate containing said contact and a patterned solder mask having an aperture exposing less than the entire first surface of said electrical contact pad.

With such an arrangement, by providing an aperture that exposes less than the entire surface of the contact, the aperture can be used to completely contain a solder material during a subsequent solder reflow operation. It is now appreciated that it is not necessary, and is in fact undesirable to completely isolate the solder mask material from the contact pad. By allowing the soldermask material to at least partially overlay the contact pad, better adhesion for the soldermask is achieved since there is an increase in the surface area in contact with the soldermask between adjacent contact pads. Further, the stencil used to place the solderpaste is now easier and less expensive to produce and results in a thicker solderpaste deposition with no increase in stencil thickness and no concomitant decrease in density.

A method of providing a solder mask on a printed wiring board having at least one electrical contact pad disposed thereon includes the steps of applying a layer of a curable solder-resistant material over a first surface of said printed wiring board, and forming in said curable solder mask layer at least one aperture exposing less than the entire first surface of at least one underlying electrical contact pad.

With such a method providing an aperture in a soldermask that exposes less than the entire surface of the contact, electronic modules can be made with improved device yield rates, improved long term solder joint reliability, and with reduced module manufacturing cost. Both the Printed Wiring Board (PWB) manufacturing area and the Electronic Board assembly area will have improved yield with the present invention.

The benefits obtained by the use of the described apparatus and method include producing electronic modules with improved device yield rates, improved long term solder joint reliability, and with reduced module manufacturing cost. The described apparatus and method address the above mentioned problems by improving PWB manufacturing yield rates because conditions that were previously rejectable, namely misaligned soldermask to metallization pad patterns, are now acceptable. Board assembly yield rates also improve under the present invention because during reflow soldering of components onto the PWB, the liquid solder can not 'wet' or stick to the soldermask, which creates a potential dam between neighboring fine pitch pads, thereby drastically reducing the incidence of stable solder bridges, which are defects. Practice has shown that this structure will cause any liquid bridge or defect between two pads, formed by an accidental bridge of solder paste, to become unstable and break apart during the reflow process.

Improved long term solder joint reliability results because the gasketed soldermask deposits more solder paste for a given stencil thickness and contains the solder during the reflow operation, resulting in thicker or taller solder joints that have more thermal and mechanical compliance. Thus the solder joints formed have been experimentally found to survive longer exposure to environmental conditions, such as thermal cycling, than prior solder joints.

Reduced module manufacturing cost results for many of the same reasons given above with reference to module improved yields, and additionally because the gasketed solder mask allows for smaller distances between adjacent metal lines and pads, thus resulting in an increase in component density on the PWB module. Smaller PWB area for the same circuitry results in a larger number of finished boards that can be cut out of a single standard sized manufacturing master board, and thus more usable product for the same manufacturing cost and effort.

In summary, the present invention will reduce PCB and board manufacturing costs by:
- Reducing the defect rate due to solder bridges in board manufacturing.
- Reduce the PWB material cost by eliminating one PWB defect mode. Whereas the previous PWB manufacturing art considered soldermask on a pad to be a defect, the present invention allows and actually designs a structure which has soldermask on pads.
- Reducing PWB manufacturing cost by relaxing the soldermask registration requirements.
- Reducing PWB defects which result from adhesion failure between the thin soldermask web between pads and the base PWB material.
- Indirectly reducing PWB cost by permitting the practical high volume high yield use of fine pitch devices, thus leading to increased circuit density and correspondingly smaller PWBs.

### BRIEF DESCRIPTION OF THE DRAWINGS

A more detailed understanding of the invention can be had from the following description of a preferred embodiment, given by way of example and to be understood in conjunction with the accompanying drawing wherein:
FIG. 1 is a cross sectional view of a PWB in accordance with an embodiment of the present invention;
FIG.s 2A-2E are a series of cross sectional views depicting the process steps used to make a PWB in accordance with a preferred embodiment of the present invention;
FIG.s 3A-3C are a series of top views of PWB metallization contact pads showing alternative embodiments of a soldermask;
FIG. 4 is a cross sectional view of a PWB having a solder paste pattern mis-aligned to the PWB; and
FIG. 5 is a cross sectional view of a PWB with the solder mask mis-sized due to processing variations.

### DESCRIPTION OF THE PREFERRED EMBODIMENTS

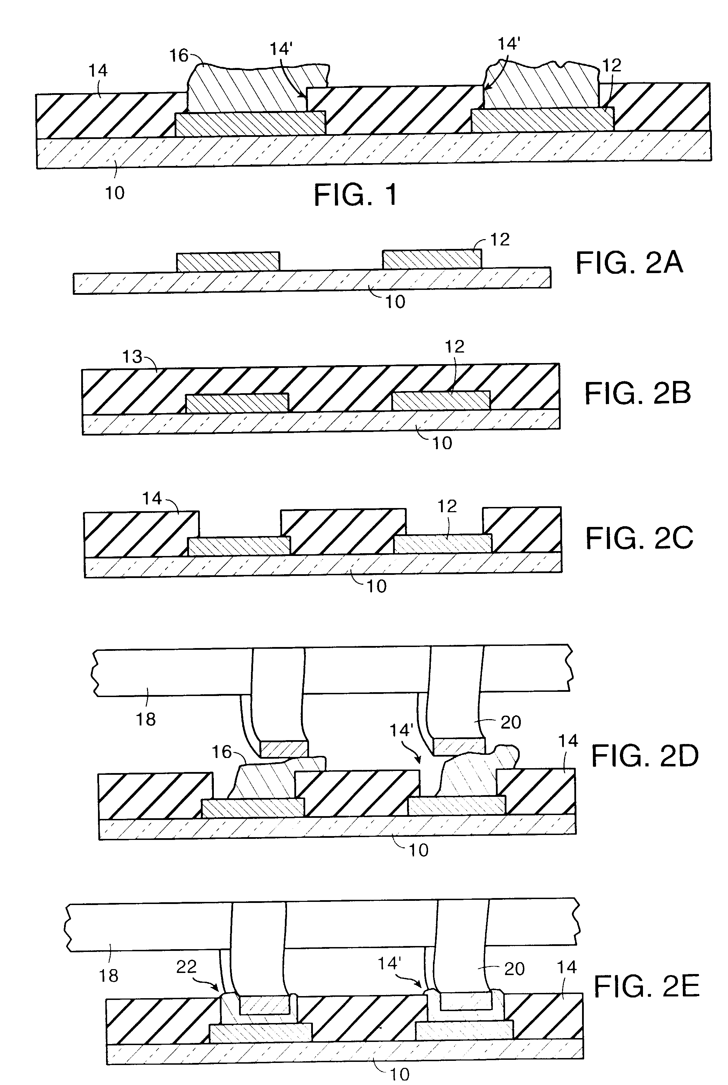

Referring to FIG. 1, a PWB substrate 10 having metal contact pads 12 disposed thereon is shown. Generally the PWB substrate is a non conductive polymer material which serves as a base for the formation of conductive metal pads and metal interconnect, respectively suited to the solder attachment and interconnection of electronic components. Here the metal pads are typically 0.036mm (1.4 thousandths of an inch) thick, as is typical in the art. The PWB substrate may be a multilayered dielectric material with a plurality of metal conductor layers. Silk screen or stencil printed solder paste patterns 16 are provided on electrical contact pads using well known techniques. The solder paste is typically comprised of small balls of solder in a matrix of rosin flux materials. Here the solder paste pattern is typically 6 thousandths of an inch thick, as is typical in the art. The paste is deposited onto the metal solder attach pads through the stencil which is aligned to the pads either mechanically or visually. Here the stencil is typically 6 thousandths of an inch thick, as is typical in the art. The assembly of the finished electronic module is accomplished by mechanically or visually aligning and placing the leads of the electronic component on the metal pads containing the solder paste, and then heating the assembly to the reflow or melting temperature of the solder paste, to provide electrical and mechanical solder connections between the PWB 10 and the electronic component.

The contact pads 12 are separated from each other by a solder mask 14 so that flaws in the deposition or handling of a solder paste 16 do not result in electrical shorts between adjacent contact pads 12 during the solder reflow attachment of the leads of an electronic device (not shown). Here the soldermask 14 is shown disposed over the surface of PWB substrate 10 having apertures 14' which expose portions of the underlying metal pads 12. The aperture 14' exposes less than the entire surface of the metal pad 12 so that the solder mask 14 overlaps portions of the metal pads 12. Here the soldermask is typically 0.038mm to 0.051mm (1.5 to 2.0 thousandths of an inch) thick over the substrate 10, and 0.012mm to 0.02mm (0.5 to 0.8 thousandths of an inch) thick over the metal pads 12, as opposed to 0.025mm to 0.036mm (1.0 to 1.4 thousandths of an inch) thick as is typical in the art.

In prior art PWB substrates, misapplied solder paste can cause an unintended electrical connection or solder bridge between adjacent metal pads, resulting in a short circuit and a failure in the absence of a solder mask. To avoid bridges it is necessary to either increase the spacing between the two adjacent metal pads, thus resulting in decreased electronic board density, or to increase the manufacturing process controls and inspections thus increasing the electronic assembly cost. This problem is the motivation for the use of solder masks, which repel liquid solder during the reflow process, and inhibit the formation of bridges and the electrical failures that bridges cause. However, in the prior art the solder mask was not allowed to overlap or touch the metal contact pads because it was widely held that any material (such as soldermask) which encroaches on the bond pad potentially jeopardizes the reliability and assembly process yields. Thus typically the width of the solder mask lines in the spaces between the metal contact pads was made as small as possible to minimize the concomitant loss in density. These requirements however pose a problem of reduced solder mask adhesion to the PWB substrate between the metal contact pads.

The soldermask 14 as shown in Fig. 1 however, completely contains the solder paste 16 on the metal pads 12. Since the pad 12 is recessed below the surface of the soldermask 14, and since the stencil (not shown) would rest upon the solder mask instead of on the metal pad, a thicker deposit of solder paste 16 can be achieved with out increasing the thickness of the stencil. An increase in the stencil thickness would result in lower pad density and higher stencil cost. Thus the solder joint height and, therefore reliability, is improved.

The soldermask 14 in the present invention overlaps the metal pads 12, as opposed to the prior art soldermask, where the soldermask is required to have some separation between the soldermask and the metal pads. As a result, the space between the two metal pads 12 can be smaller than in the prior art. Current practice requires a clearance between the pad and soldermask to accommodate any variances in soldermask/pad alignment. Current practice also requires a minimum 'soldermask web' width (ie the width of the soldermask between adjacent pads) to ensure adequate adhesion between the soldermask and the PWB material. Therefore, the minimum pitch is determined by minimum 'web' width plus clearance plus bond pad width. The present invention eliminates the clearance requirement, and indeed provides a negative clearance (ie overlaps) between the soldermask and the bond pad. Therefore the minimum pitch is reduced leading to higher density, smaller and less expensive board assemblies. The present invention also improves 'web' adhesion over the prior art because the solder mask overlap onto the contact provides increased surface contact area due to the corners and side walls of the electrical contact that the soldermask covers.

Referring now to FIG.s 2A-2E, steps used to provide the PWB having the solder mask 14 are shown. As shown in FIG. 2A, a PWB substrate 10 has a pair of metal contact pads 12 disposed over a surface thereof. The contact pads 12 are specially placed and spaced to be capable of receiving the conductor leads of a specific electronic component.

As shown in FIG. 2B, a continuous layer 13 of a solder mask material is deposited over a surface of the substrate 10 and metal pads 12. Here the material is deposited by spraying a liquid photoimageable solder mask material onto the PWB. The optical polarity of the liquid photoimageable solder mask here used is negative, meaning that where the material is exposed to light it is retained during the development procedure.

As is also shown in FIG. 2C the layer 13 (FIG. 2B) is patterned by exposing the layer to light and chemically developing the unexposed area to selectively remove the solder mask material in regions aligned over the metal pads. Here the soldermask 14 is patterned to provide apertures which expose portions of the underlying metal contact pads 12.

As shown in FIG. 2D the solder paste 16 is deposited in the apertures 14' in the soldermask 14 by silk screen or stencil depositing in the exposed areas of the contact pads. The leads 20 of the electronic component 18 are visually or mechanically aligned to the contact pad layer 12 and placed in the area of the contact pads. Here the solder paste 16 is shown misaligned to the right of the correct location, and the component leads 18 are also shown slightly misaligned to the right. In the prior art, such a misalignment as shown would result in a change in the solder bonding area, volume and height, which would result in a reduced solder height and lower reliability. Here however, the aperture 14' in soldermask 14 ensures that the total volume of the deposited solder paste 16 will reside within the aperture 14' after the reflow operation. Thus the solder volume and height are controlled, and solder joint quality is improved.

FIG. 2E shows the PWB after the reflow soldering operation. The solder paste 16 is been melted and converted into solder 22. The solder is aligned with the contact pad because the liquid solder does not 'wet' the soldermask 14, and thus is drawn back into the aperture 14' and to the metal pad 12, which does 'wet' to the solder. The component lead 20 is also drawn into better alignment with the contact pad and is partially submerged in the solder creating a strong mechanical and electrical joint.

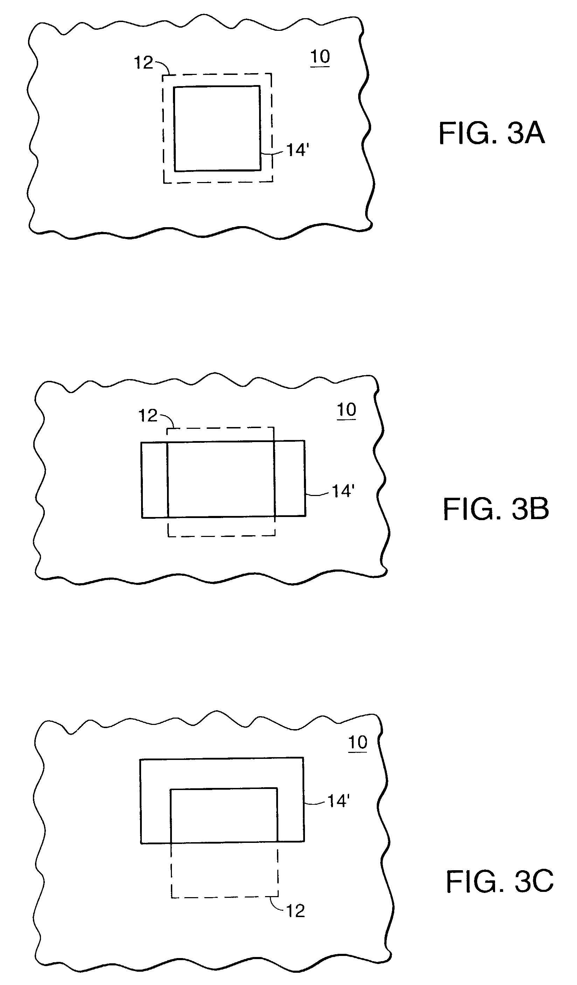

Now referring to FIG.s 3A-3C, alternative embodiments of the present invention are shown. FIG. 3A shows the aperture 14' of the solder mask 14 being completely contained within the perimeter of the metal contact pad 12.

Thus no edge of the contact pad 12 is exposed. FIG. 3B shows the case where the aperture 14' of the solder mask intentionally overlaps onto the PWB substrate 10. Thus parts of the contact pad 12 perimeter are exposed. This situation potentially reduces the defects caused by entrapment of the solder flux or other gases during the reflow process in the ends of the aperture. FIG. 3C shows the case where the solder mask aperture 14' is misaligned to the metal pad.

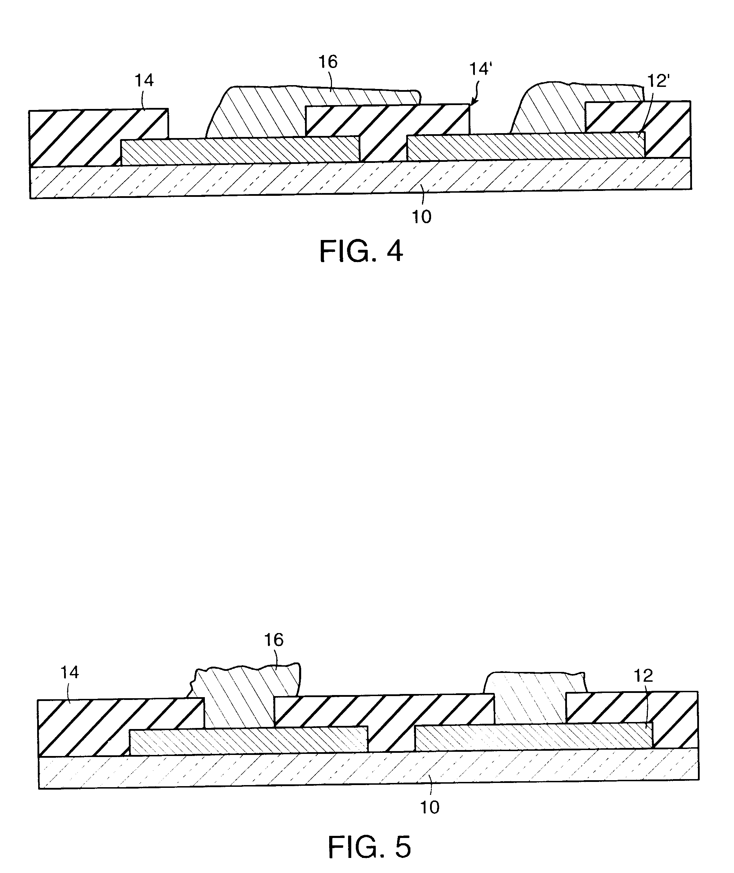

Now referring to FIG. 4, the present invention is shown in a cross sectional view with badly misaligned solder paste. In the present invention the prior art requirement for accurate visual or mechanical alignment of the solder paste 16 to the metal pad pattern is eliminated. As is shown in FIG. 4, the solder paste can be so badly misaligned that it would have contacted both adjacent metal pads 12 in the prior art solder mask case, and yet still form acceptable solder joints after reflow attach of the electronic components. This is again because the liquid solder is not able to stick to the solder mask 14, and is drawn back to the aperture 14' and the metal pad 12 during the reflow process.

Another feature shown in FIG. 4 is the oversized metal pads 12 (contrast to FIG. 1) that result from the present invention's ability to reduce the metal pad to metal pad spacing mentioned above. Thus, with the same overall metal line width pitch it is possible to increase the metal pad size as compared to the prior art. Increased metal pad size allows the present invention to increase the yield of the alignment process while decreasing the accuracy requirement of the electronic component to PWB visual or mechanical alignment process. This results in increased yield and decreased process complexity and cost.

Now referring to FIG. 5, the present invention is shown in a cross sectional view with a badly mis-sized solder mask. The prior art requirement for accurate size control for the solder mask photolithography image is relaxed for the present approach because the solder mask opening need only be somewhere on the metal pad 12 rather than tightly controlled with respect to all of the edges of the metal pads as with the prior art. In addition, if the solder mask was so badly misaligned that there was not complete containment of the opening on the metal pad 12, then the situation would in any case be no worse than the standard case of the prior art wherein the opening of the soldermask always was off of the metal pad.

While the foregoing description illustrates preferred embodiments of the invention, modifications and variations of the invention are within the scope of the invention defined by the appended claims.

## Claims

1. A printed wiring board comprising:
a substrate having at least one electrical contact pad disposed over said substrate, said electrical contact pad having a first surface; and
a patterned solder mask disposed upon said substrate and having an aperture exposing less than the entire first surface of said electrical contact pad; wherein said solder mask exposes portions of said electrical contact pad and adjacent portions of said substrate.

2. The printed wiring board of Claim 1 wherein said aperture in said solder mask is entirely contained within said electrical contact pad.

3. The printed wiring board of Claim 1 wherein said patterned solder mask has a thickness sufficient to entirely contain reflowed solder.

4. The printed wiring board of Claim 1 wherein said patterned solder mask is comprised of a liquid photo imagable material.

5. A method of providing a solder mask on a printed wiring board having at least one electrical contact pad disposed thereon, said method comprising the steps of:
applying a layer of a curable solder-resistant material over a first surface of said printed wiring board; and
forming in said curable solder mask layer at least one aperture exposing less than the entire first surface of at least one underlying electrical contact pad.

6. The method of claim 5 wherein said aperture in said solder mask overlaps portions of said electrical contact pad and exposes portions of said printed wiring board.

7. The method of claim 5 wherein said aperture in said solder mask is entirely contained within said electrical contact pad.

8. The method of claim 5 wherein said layer of a curable solder-resistant material has a thickness sufficient to entirely contain reflowed solder within said aperture.

9. The method of claim 5 wherein, said layer of curable solder-resistant material comprises a liquid photoimagabable material.
